# EUROPÄISCHE PATENTANMELDUNG

(11) **EP 0 856 890 A1**
(43) Veröffentlichungstag der Anmeldung: **05.08.1998**
(21) Anmeldenummer: 98100484.9
(22) Anmeldetag: 13.01.1998
(51) Int. Cl.: H01L 27/108, H01L 27/118

(54) **Anwendungsspezifisches integriertes Halbleiterprodukt mit Dummy-Elementen**

(30) Priorität: 31.01.1997 DE 19703611
(71) Anmelder: SIEMENS AKTIENGESELLSCHAFT, 80333 München (DE)
(72) Erfinder: Ludwig, Christoph, Dr., 01465 Langebrück (DE); Hübl, Markus, 85570 Markt Schwaben (DE); Steurich, Björn, 80797 München (DE)

(57) **Zusammenfassung**

Erfindungsgemäß wird ein anwendungsspezifisches integriertes Halbleiterprodukt mit zumindest einer Speichereinheit bereitgestellt, wobei die Speichereinheit eine Vielzahl von Speicherzellen umfaßt, welche jeweils zumindest einen Speicherkondensator aufweisen, und wobei das integrierte Halbleiterprodukt zusätzliche Dummy-Elemente besitzt. Diese Dummy-Elemente besitzen in dem fertigen Halbleiterprodukt keine selbstständige Funktion. Insbesondere sind die Dummy-Elemente so gewählt, daß die Prozeßparameter für die Prozeßschritte zur Herstellung der Speicherkapazitätselemente von dem anwendungsspezifischen, integrierten Halbleiterprodukt im wesentlichen unabhängig sind. Durch diese zusätzlichen Dummy-Elemente werden die im Verlauf des Herstellungsverfahrens auftretenden wesentlichen Topologieunterschiede zwischen verschiedenen anwendungsbezogenen integrierten Halbleiterprodukten weitgehend abgebaut.

## Beschreibung

Die vorliegende Erfindung betrifft ein integriertes Halbleiterprodukt, insbesondere ein anwendungsspezifisches integriertes Halbleiterprodukt, sowie ein Logikelement für ein derartiges integriertes Halbleiterprodukt.

Zukünftig wird zunehmend ein Bedarf nach anwendungsspezifischen integrierten Halbleiterprodukten für die unterschiedlichsten Anwendungen entstehen, die neben den für den jeweiligen Anwedungszweck benötigten Logikeinheiten Speichereinheiten mit individuell an die jeweiligen Bedürfnisse angepaßten Speicherkapazitäten aufweisen. Man spricht in diesem Zusammenhang von 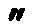 embedded solutions" oder von 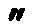 embedded RAM-Produkten". Es wurde festgestellt, daß durch die Integration von RAM-Strukturen auf dem anwendungsspezifischen Halbleiterprodukt eine deutliche Steigerung der Systemleistung erzielt wird. So können bei einer derartigen Anordnung Speicherzugriffe oft innerhalb eines Systemtakts durchgeführt werden. Als Beispiel seien integrierte Halbleiterprodukte für die Sprachanalyse und Spracherkennung angeführt, welche die Signale, die die gesprochene Sprache repräsentieren, in einem integrierten Speicher für eine gewisse Zeit speichern, damit die Logikeinheiten in der Lage sind, die Signale zu analysieren.

Üblicherweise wurden diese integrierten Speichereinheiten als statische Speichereinheiten (SRAM) ausgelegt. Bedingt durch die gegenüber statischen Speichereinheiten höhere Speicherdichte von dynamischen Speichereinheiten wäre es wünschenswert, wenn auch dynamische Speichereinheiten in ein anwendungsspezifisches Halbleiterprodukt integriert werden könnten. Bei der Entwicklung derartiger anwendungsbezogener Halbleiterprodukte tritt jedoch das Problem auf, daß unterschiedliche integrierte Halbleiterprodukte mit unterschiedlichen Speicherdichten (Speicherdichte = Speicherkapazität pro Flächenmaß) eine produktspezifische Prozeßentwicklung zu ihrer Herstellung erfordern. Dies ergibt sich aus der Tatsache, daß je nach Anwendungsgebiet verschiedene Funktionselemente, verschiedene Gesamtspeicherkapazitäten sowie unterschiedliche Anordnungen der einzelenen Einheiten auf dem Halbleiterprodukt notwendig sind. Daraus ergeben sich während der Herstellung der unterschiedlichen Halbleiterprodukte, insbesondere bei der Verwendung von dynamischen Speichereinheiten, unterschiedliche Oberflächentopologien.

Der Herstellungsprozeß für einen hochintegrieten Chip, der sich aus einer langen Reihe von Einzelprozessen (z.B. Aufbringen verschiedener Schichten, Dotieren, laterale und vertikale Strukturierung und Ätzen einzelner Schichten) mit einer Vielzahl von Prozeßparametern (z.B. Temperatur des Substrats, Zusammensetzung und Menge der verwendeten Ätzgase, ...) zusammensetzt, ist jedoch üblicherweise auf eine bestimmte Topologie des zu erzeugenden Chips ausgelegt. Insbesondere die Prozeßparameter für die Prozeßschritte zur Herstellung der Speicherkondensatoren sind in der Regel auf eine vorgegebene Gesamtspeicherkapazität ausgelegt.

Versucht man nun den für ein bestimmtes anwendungsbezogenes Halbleiterprodukt, insbesondere für eine bestimmte Speicherdichte ausgelegten Prozeß dadurch für ein anderes anwendungsbezogenes Halbleiterprodukt zu verwenden, daß man im wesentlichen alle Prozeßparameter beibehält und nur die Masken zur Strukturierung des Chips austauscht, so führt diese Vorgehensweise in der Regel nicht zum Erfolg. Insbesondere bei den Prozeßschritten zur Herstellung der Speicherkapazitätselemente führen unveränderte Prozeßparameter bei unterschiedlichen Halbleiterprodukten zu Schwierigkeiten, denn die unterschiedlichen Topologien der verschiedenenen anwendungsbezogenen Halbleiterprodukte ergeben bei sonst gleichen Parametern unterschiedliche Abscheide- und Ätzraten während der Herstellung ( 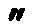 Loading-Effekt").

Würde man beispielsweise versuchen, den Herstellungsprozeß, der für die Herstellung eines 16M-Bit Standard-DRAMs mit Grabenkondensatoren verwendet wird, zur Herstellung einer 0,5M-Bit Speichereinheit auf einem Chip gleicher Fläche zu verwenden, konnte die Nitridschicht, die beim Ätzen der Kondensatorgräben das restlichen Siliziumsubstrat schützt, zerstört werden, weil für die relativ geringe Zahl von zu ätzenden Kondensatorgräben zuviel Ätzgas vorhanden ist.

Somit muß bisher für jedes neue Halbleiterprodukt ein neuer Herstellungsprozeß für die Speicherzellen entwickelt werden, der an das konkrete Layout des jeweiligen Produkts angepaßt ist. Darüberhinaus können die für die hoch integrierten Standardspeicher entwickelten Herstellungsprozeße nicht direkt für die anwendungsbezogenen Halbleiterprodukte verwendet werden. Dies steht einer wirtschaftlichen Fertigung einer großen Produktvielfalt anwendungsbezogener Halbleiterprodukte entgegen.

Der Erfindung liegt daher die Aufgabe zugrunde, anwendungsspezifische integrierte Halbleiterprodukte, Logikelemente sowie Verfahren zum Entwurf der integrierten Halbleiterprodukte anzugeben, die eine im wesentlichen designinvariante Herstellung der unterschiedlichen Halbleiterprodukte, insbesondere eine im wesentlichen designinvariante Herstellung der Speichereinheiten der Halbleiterprodukte ermöglichen.

Diese Aufgabe wird durch das anwendungsspezifische integrierte Halbleiterprodukt gemaß dem unabhängigen Patentanspruch 1, das Logikelement gemäß dem unabhängigen Patentanspruch 11 sowie dem Verfahren gemaß Patentanspruch 16 gelöst. Weitere vorteilhafte Ausführungsformen, Ausgestaltungen und Aspekte der vorliegenden Erfindung ergeben sich aus den Unteransprüchen, der Beschreibung und den beiliegenden Zeichnungen.

Erfindungsgemäß ist ein anwendungsspezifisches integriertes Halbleiterprodukt mit zumindest einer Speichereinheit vorgesehen, die eine Vielzahl von Speicherzellen umfaßt, welche jeweils zumindest einen Speicherkondensator aufweisen, wobei das integrierte Halbleiterprodukt zusätzliche Dummy-Elemente besitzt.

Diese Dummy-Elemente besitzen in dem fertigen Halbleiterprodukt keine selbstständige Funktion. Insbesondere sind die Dummy-Elemente so gewählt, daß die Prozeßparameter für die Prozeßschritte zur Herstellung der Speicherkapazitätselemente von dem anwendungsspezifischen, integrierten Halbleiterprodukt im wesentlichen unabhängig sind.

Durch diese zusätzlichen Dummy-Elemente werden die im Verlauf des Herstellungsverfahrens auftretenden wesentlichen Topologieunterschiede zwischen verschiedenen anwendungsbezogenen integrierten Halbleiterprodukten weitgehend abgebaut.

Insbesondere ist es bevorzugt, daß die Dummy-Elemente die Struktur der Speicherkondensatoren aufweisen. Für den Fall, daß der Speicherkondensator ein Grabenkondensator ist, ist es ausreichend, wenn die Dummy-Elemente die Struktur des Speicherkondensatorgrabens aufweisen, d.h. es ist ausreichend, wenn jeweils im Halbleitersubstrat ein den Speichergrabenkondensatoren entsprechender Graben ausgebildet ist. Die für die Funktionsfähigkeit eines Speicherkondensators darüber hinaus notwendigen dielektrischen Schichten (beispielsweise eine Oxid/Nitrid/Oxid-Schicht) sowie die weiteren leitenden Schichten müssen nicht vorhanden sein.

Somit kann ein Herstellungsprozeß entwickelt werden, bei dem eine festgelegte Gesamtzahl N von Speicherkondensatoren und Dummy-Elementen pro Flächenmaß vorgesehen ist. Erfordert die Funktionfähigkeit des Chips eine bestimmte Anzahl von Speicherkondensatoren NS pro Flächenmaß, so werden in das Layout des Chips (N - NS) funktionslose Dummy-Elemente pro Flächenmaß eingefügt. So läßt sich auch eine große Produktvielfalt an anwendungsspezifischen Halbleiterprodukten wirtschaftlich fertigen.

Für eine möglichst flexible Fertigung ist es von Vorteil, wenn die von den Dummy-Elementen eingenommene Fläche größer als 20%, bevorzugt großer als 100%, der von den Speicherkondensatoren eingenommenen Fläche ist.

Bevorzugt ist die von den Speicherkondensatoren und den Dummy-Elementen eingenommene Fläche großer als 3.5%, insbesondere größer als 7%, der Gesamtfläche des integrierten Halbleiterprodukts.

Darüberhinaus ist bevorzugt, wenn die Dummy-Elemente auf der Restfläche des integrierten Halbleiterprodukts außerhalb der Speichereinheit angeordnet sind.

Üblicherweise besitzen integrierte Halbleiterprodukte eine oder mehrere Logikeinheiten, durch die die anwendungsspezifische Funktion des integrierten Halbleiterprodukts realisiert ist. Häufig besitzen derartige Logikeinheiten nicht denselben hohen Integrationsgrad wie er bei Speichereinheiten verwirklicht werden kann. Daher ist es bevorzugt, daß zumindest ein Teil der Dummy-Elemente in der Logikeinheit angeordnet ist.

Weiterhin wird erfindungsgemäß ein Logikelement, insbesondere eine Gate-Array-Zelle, für ein integriertes Halbleiterprodukt bereitgestellt, das zumindest eine Speichereinheit aufweist, die aus einer Vielzahl von Speicherzellen aufgebaut ist, welche jeweils zumindest einen Speicherkondensator aufweisen. Das Logikelement weist zumindest ein Schaltelement und zumindest ein Dummy-Element auf.

Das Dummyelement besitzt bevorzugt die Struktur der Speicherkondensatoren, bzw. wenn die Speicherkondensatoren Grabenkondensatoren sind, die Struktur des Speicherkondensatorgrabens.

Weiterhin ist es bevorzugt, wenn das Schaltelement ein Transistor, insbesondere ein MOS-Transistor ist.

Die vorliegende Erfindung wird nun anhand der beiliegenden Zeichnungen naher erläutert. Es zeigen
Fig. 1 eine schematische Darstellung eines erfindungsgemäßen anwendungsspezifischen integrierten Halbleiterprodukts,
Fig. 2 eine schematische Darstellung eines Schnitts durch das erfindungsgemäße Halbleiterprodukt,
Fig. 3 eine schematische Darstellung eines Schnitts durch ein Logikelement ohne Dummy-Elemente,
Fig. 4 eine schematische Darstellung eines Schnitts durch ein erfindungsgemäßes Logikelement mit Dummy-Elementen,
Fig. 5 eine schematische Aufsicht auf eine Gate-Array Zelle ohne Dummy-Elemente, und
Fig. 6 eine schematische Aufsicht auf eine erfindungsgemäße Gate-Array Zelle mit Dummy-Elementen.

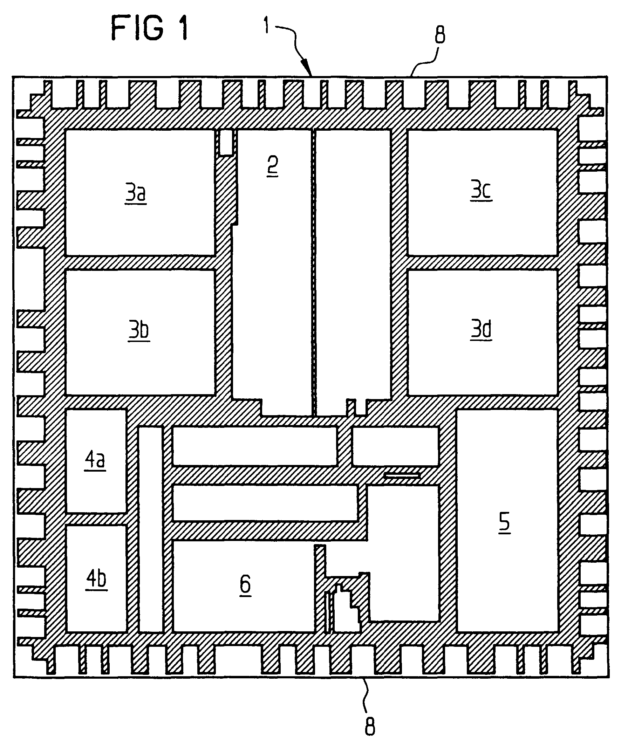

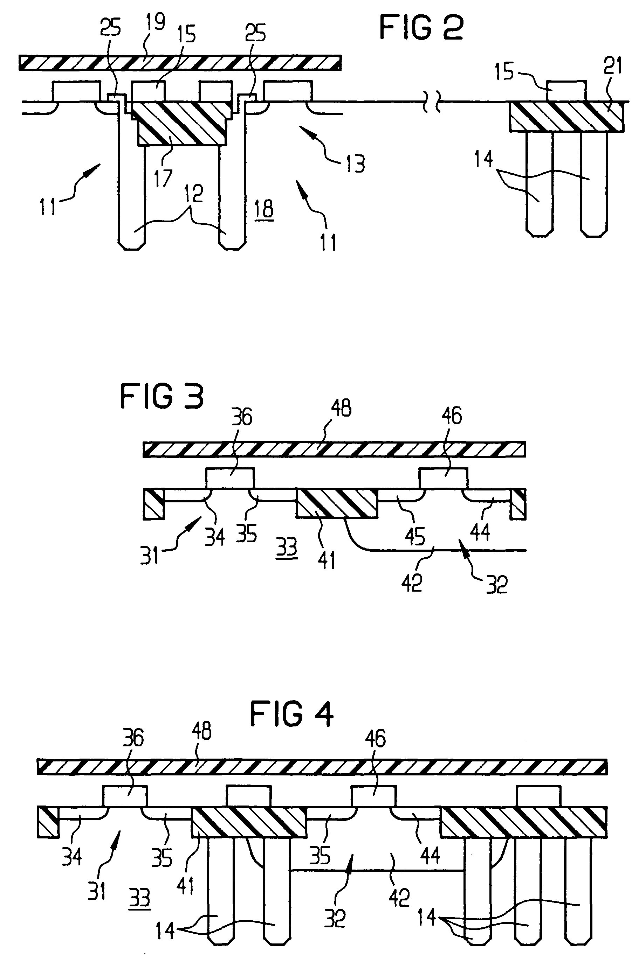

Fig. 1 zeigt eine schematische Darstellung eines erfindungsgemäßen anwendungsspezifischen integrierten Halbleiterprodukts 1. Das Halbleiterprodukt 1 ist ein hochintegrierter Siliziumchip. Es weist eine Logikeinheit 2, dynamische Speichereinheiten 3a bis 3d, statische Speichereinheiten 4a und 4b, eine ROM-Einheit 5 sowie eine Prozessoreinheit 6 auf. Diese verschiedenen Einheiten sind über zwischen den Einheiten verlaufende Aluminium-Leitungen 19 und Polysiliziumleitungen 15 (siehe Fig. 2) miteinander verbunden. Wie unter Bezugnahme auf Fig. 2 noch näher erläutert werden wird, bestehen die Speichereinheiten 3a bis 3d aus einer Vielzahl von Speicherzellen 11, die jeweils einen Speichergrabenkondensator 12 und MOS-Transistor 13 aufweisen. Die Speichergrabenkondensatoren 12 und die MOS-Transistoren 13 einer Speicherzelle 11 sind jeweils über einen sogenannten 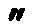 Surface Strap" 25 miteinander verbunden. Die Speichereinheiten 3a bis 3d sind beispielsweise nach dem Prozeß hergestellt, der auch für die Herstellung von 16M-Bit Standardspeichern verwendet wird. Wie aus Fig. 1 ersichtlich nehmen die Speichereinheiten 3a bis 3d nur einen geringen Teil der verfügbaren Chipfläche ein. Die Speichergrabenkondensatoren 12 selbst belegen nur etwa 2.9% der verfügbaren Chipfläche.

Um nun Loadingeffekte bei der Herstellung des integrierten Chips zu verhindern, werden zusätzliche Dummy-Grabenkondensatoren 14 (siehe Fig. 2) auf der in Fig. 1 dunkel dargestellten Fläche 8 angeordnet. Diese zusätzlichen Dummy-Grabenkondensatoren 14 erfüllen im fertigen Produkt keine Funktion. Sie sind von den restlichen Bauelementen des Chips vollständig isoliert. Die zusätzlichen Dummy-Grabenkondensatoren 14 verhindern insbesondere, daß der bei der Herstellung der Speichergrabenkondensatoren 12 verwendete Ätzschritt die Nitridschicht zerstört, die während der Herstellung zum Schutz des Siliziumsubstrats auf die restliche Fläche des Chip aufgebracht wird. Da die Logikeinheit 2 nicht so hoch integriert wie die Speichereinheiten 3a bis 3d ist, sind auch in der Logikeinheit 2 Dummy-Grabenkondensatoren 14 angeordnet (siehe Figur 4).

Durch die Dummy-Grabenkondensatoren 14 steigt der Anteil der Chipfläche, der von den Grabenkondensatoren 12 bzw. 14 eingenommen wird, auf etwa 11% der Gesamtchipfläche.

Fig. 2 zeigt eine schematische Darstellung eines Schnitts durch das erfindungsgemäße Halbleiterprodukt. Fig. 2 zeigt auf der linken Seite der Zeichnung eine schematische Darstellung zweier Speicherzellen 11 in einer der Speichereinheinten 3a bis 3d. Jede Speicherzelle 11 umfaßt einen Speichergrabenkondensatoren 12 und einen MOS-Transistor 13. Die einzelnen Speicherzellen 11 sind durch Isolatorbereiche 17 von einander getrennt. Die Verbindung einer Speicherzelle 11 mit dem restlichen Chip erfolgt über eine oder mehrere Metallisierungsebenen 19 und über eine oder mehrere Polysiliziumebenen 15.

Um beim Auslesen einer Speicherzelle ein ausreichend großes Lesesignal zu erhalten und um gegenüber Störung durch ionisierende Strahlung, insbesondere Alpha-Teilchen unempfindlich zu sein, sollte die Speicherkapazität etwa 35 fF oder mehr betragen. Die dazu benötigte Kondensatorfläche liegt üblicherweise in der Größenordnung von 10 µm² . Bei der inzwischen erreichten Integrationsdichte von dynamischen Speicherzellen kann diese Fläche nicht mehr durch eine planare Anordnung des Speicherkondensators zur Verfügung gestellt werden. Es wurden deshalb Grabenkondensatoren entwickelt, die auch die dritte Dimension eines Chips nutzen und tief in das Substrat 18 des Chips reichen. Auf diese Weise kann einerseits die benötigte Kondensatorfläche zur Verfügung gestellt werden. Andererseits sind die Grabenkondensatoren für die deutlichen Topologieunterschiede verantwortlich, die zwischen den dynamischen Speichereinheiten und den übrigen Einheiten eines anwendungsspezifischen Chips während der Herstellung auftreten.

Um diese Topologieunterschiede auszugleichen, sind in den anderen Bereichen dieser Ausführungsform des erfindungsgemäßen Halbleiterprodukts, außerhalb der dynamischen Speichereinheiten 3a bis 3d, Dummy-Grabenkondensatoren 14 vorgesehen. So sind, wie in Fig. 2 auf der rechten Seite gezeigt, unterhalb der Leitungen 15, welche die einzelnen Einheiten des Chips miteinander verbinden, Dummy-Grabenkondensatoren 14 vorgesehen. Diese Dummy-Grabenkondensatoren 14 sind durch einen Isolatorbereich 21 von den Leitungen 15 getrennt. Die Dummy-Grabenkondensatoren 14 stimmen nicht bis in jedes Detail mit den Speichergrabenkondensatoren 12 der Speicherzellen 11 überein. So besitzen die Dummy-Grabenkondensatoren 14 beispielsweise keinen 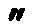 Surface Strap" 25, der die Speichergrabenkondensatoren 12 mit den MOS-Transistoren 13 der Speicherzellen 11 verbindet. Es ist ausreichend, wenn die Dummy-Grabenkondensatoren 14 während der Herstellung die generelle Struktur, insbesondere die generelle topologische Struktur der Speichergrabenkondensatoren 12 wiederspiegeln. Es ist nicht notwendig, daß die Dummy-Grabenkondensatoren 14 funktionstüchtige Kondensatoren bilden.

Fig. 3 zeigt eine schematische Darstellung eines Schnitts durch ein Logikelement ohne Dummy-Elemente. Fig. 3 zeigt eine CMOS-Struktur, welche sich aus einem n-Kanal-MOSFET 31 und einem p-Kanal-MOSFET 32 auf einem p-Substrat 33 zusammensetzt. Der n-Kanal-MOSFET 31 besitzt einen n⁺ - dotierten Sourcebereich 34 und einen n⁺ - dotierten Drainbereich 35. Durch das Anlegen einer Spannung an den Gatebereich 36 wird der n-Kanal-MOSFET 31 geschaltet. Der p-Kanal-MOSFET 32 besitzt einen p⁺ - dotierten Sourcebereich 44 und einen p⁺ -dotierten Drainbereich 45, die in einer n-Wanne 42 ausgebildet sind. Der p-Kanal-MOSFET 32 wird durch das Anlegen einer Spannung an den Gatebereich 46 geschaltet. Die verschiedenen MOS-Transistoren werden durch eine oder mehrere Metallisierungsebenen 48 entsprechend der zu realisierenden Logikfunktionen miteinander verbunden. Um die Transistoren voneinander zu trennen, ist zwischen dem n-Kanal-MOSFET 31 und dem p-Kanal-MOSFET 32 ein Isolatorbereich 41 angeordnet.

Um nun auch die Topologieunterschiede, die zwischen den dynamischen Speichereinheiten und den Logikeinheiten während der Herstellung des Chips auftreten, auszugleichen, sind auch, wie in Fig. 4 gezeigt, in der Logikeinheit Dummy-Grabenkondensatoren 14 vorgesehen. Diese Dummy-Grabenkondensatoren 14 sind unterhalb der Isolatorbereiche 41 angeordnet. Auch die Dummy-Grabenkondensatoren 14 in der Logikeinheit stimmen nicht bis in jedes Detail mit den Speichergrabenkondensatoren 12 der Speicherzellen 11 überein. So besitzen die Dummy-Grabenkondensatoren 14 in der Logikeinheit ebenfalls keinen 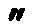 Surface Strap" 25, der die Speichergrabenkondensatoren 12 mit den MOS-Transistoren 13 der Speicherzellen 11 verbindet. Wiederum ist es ausreichend, wenn die Dummy-Grabenkondensatoren 14 während der Herstellung die generelle Struktur, insbesondere die generelle topologische Struktur der Speichergrabenkondensatoren 12 wiederspiegeln. Es ist nicht notwendig, daß die Dummy-Grabenkondensatoren 14 in der Logikeinheit funktionstüchtige Kondensatoren bilden. Die weiteren in Fig. 4 gezeigten Strukturen stimmen mit den in Fig. 3 gezeigten Strukturen überein.

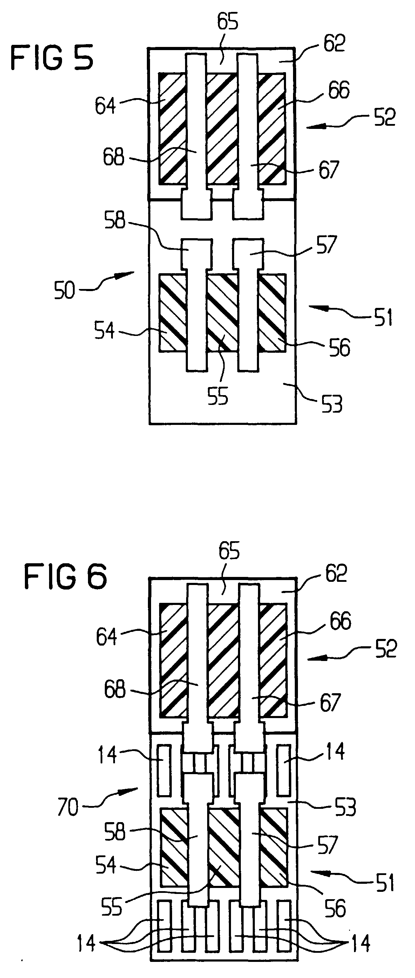

Fig. 5 zeigt eine schematische Aufsicht auf eine Gate-Array Zelle. Die Gate-Array-Zelle 50 umfaßt zwei Schaltelemente, eine n-Kanal-Transistoranordnung 51 und eine p-Kanal-Transistoranordnung 52. Bei der n-Kanal Transistoranordnung 51 sind in einem p-Substrat 53 n-dotierte Bereiche 54, 55 und 56 ausgebildet. Diese n-dotierten Bereiche bilden in der späteren Schaltung, je nach der benötigten Logikfunktion, die Source- bzw. Drainbereiche der n-Kanal-Transistoranordnung 51. Durch Anlegen von Spannung an die Gatebereiche 57, 58 der n-Kanal-Transistoranordnung 51 kann die n-Kanal-Transistoranordnung 51 geschaltet werden.

Bei der p-Kanal-Transistoranordnung 52 ist in dem p-Substrat 53 eine n-Wanne 62 ausgebildet. In dieser n-Wanne 62 sind die p-dotierten Bereiche 64, 65 und 66 angeordnet, welche in der späteren Schaltung, je nach der benötigten Logikfunktion, die Source- bzw. Drainbereiche der p-Kanal-Transistoranordnung 52 bilden. Durch Anlegen von Spannung an die Gatebereiche 67, 68 der p-Kanal-Transistoranordnung 52 kann die p-Kanal-Transistoranordnung 52 geschaltet werden.

Durch eine entsprechende Auswahl der Source-/Drainbereiche der n-Kanal- bzw. p-Kanal-Transistoranordnungen 51 und 52 sowie eine entsprechende Verdrahtung mehrerer Gate-Array-Zellen können nahezu beliege Logikfunktionen realisiert werden.

Um nun ein Gate-Array-Element für ein integriertes Halbleiterprodukt bereitzustellen, das zumindest eine Speichereinheit aufweist, die aus einer Vielzahl von Speicherzellen aufgebaut ist, sind auch, wie in Fig. 6 gezeigt, in der Gate-Array-Zelle 70 Dummy-Grabenkondensatoren 14 vorgesehen. Diese Dummy-Grabenkondensatoren 14 sind außerhalb der n- bzw. p-dotierten Source-/Drainbereiche der Transistoranordnungen 51, 52 angeordnet. Auch die Dummy-Grabenkondensatoren 14 in der Gate-Array Zelle 70 stimmen nicht bis in jedes Detail mit den Speichergrabenkondensatoren 12 der Speicherzellen 11 überein. So besitzen die Dummy-Grabenkondensatoren 14 in der Logikeinheit ebenfalls keinen 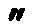 Surface Strap" 25, der die Speichergrabenkondensatoren 12 mit den MOS-Transistoren 13 der Speicherzellen 11 verbindet. Wiederum ist es ausreichend, wenn die Dummy-Grabenkondensatoren 14 während der Herstellung die generelle Struktur, insbesondere die generelle topologische Struktur der Speichergrabenkondensatoren 12 widerspiegeln. Es ist nicht notwendig, daß die Dummy-Grabenkondensatoren 14 in der Gate-Array-Zelle 70 funktionstüchtige Kondensatoren bilden.

Durch die Bereitstellung der Dummy-Grabenkondensatoren 14 wird eine Gate-Array-Zelle zur Verfügung gestellt, die automatisch an den zur Herstellung der Speichereinheit verwendeten Herstellungsprozeß angepaßt ist.

## Patentansprüche

1. Anwendungsspezifisches integriertes Halbleiterprodukt (1)
**dadurch gekennzeichnet,** daß
zumindest eine Speichereinheit (3a, 3b, 3c, 3d), die eine Vielzahl von Speicherzellen (11) umfaßt, welche jeweils zumindest einen Speicherkondensator (12) aufweisen, und
Dummy-Elemente (14) vorgesehen sind.

2. Halbleiterprodukt (1) nach Anspruch 1
**dadurch gekennzeichnet,**
daß der Speicherkondensator (12) ein Grabenkondensator ist.

3. Halbleiterprodukt (1) nach Anspruch 2
**dadurch gekennzeichnet,**
daß die Dummy-Elemente (14) jeweils die Struktur des Speicherkondensatorgrabens aufweisen.

4. Halbleiterprodukt (1) nach einem der vorhergenden Ansprüche
**dadurch gekennzeichnet,**
daß die Dummy-Elemente (14) jeweils die Struktur des Speicherkondensators (12) aufweisen.

5. Halbleiterprodukt (1) nach einem der vorhergenden Ansprüche
**dadurch gekennzeichnet,**
daß die von den Dummy-Elementen (14) eingenommene Fläche größer als 20%, bevorzugt größer als 100%, der von den Speicherkondensatoren (12) eingenommenen Fläche ist.

6. Halbleiterprodukt (1) nach einem der vorhergenden Ansprüche
**dadurch gekennzeichnet,**
daß die von den Speicherkondensatoren (12) und den Dummy-Elementen (14) eingenommene Fläche großer als 3.5% der Geamtfläche des integrierten Halbleiterprodukts (1) ist.

7. Halbleiterprodukt (1) nach einem der vorhergehenden Ansprüche
**dadurch gekennzeichnet,**
daß die von den Speicherkondensatorfeldern (12) und den Dummy-Elementfeldern (14) eigenommene Fläche größer als 7% der Gesamtfläche des integrierten Halbleiterprodukts (1) ist.

8. Halbleiterprodukt (1) nach einem der vorhergehenden Ansprüche
**dadurch gekennzeichnet,**
daß die Dummy-Elemente (14) auf der Restfläche des integrierten Halbleiterprodukts (1) außerhalb der Speichereinheit (3a, 3b, 3c, 3d) angeordnet sind.

9. Halbleiterprodukt (1) nach einem der vorhergehenden Ansprüche
**dadurch gekennzeichnet,**
daß das integrierte Halbleiterprodukt (1) zumindest eine Logikeinheit (2) aufweist.

10. Halbleiterprodukt nach Anspruch 9
**dadurch gekennzeichnet,**
daß zumindest ein Teil der Dummy-Elemente (14) in der Logikeinheit (2) angeordnet ist.

11. Logikelement (70), insbesondere Gate-Array-Zelle, für ein anwendungsspezifisches integriertes Halbleiterprodukt (1), das zumindest eine Speichereinheit (3a, 3b, 3c, 3d) aufweist, die eine Vielzahl von Speicherzellen (11) umfaßt, welche jeweils zumindest einen Speicherkondensator (12) aufweisen, mit zumindest einem Schaltelement (51, 52),
**dadurch gekennzeichnet,**
daß das Logikelement (70) zumindest ein Dummy-Element (14) aufweist.

12. Logikelement (70) nach Anspruch 11
**dadurch gekennzeichnet,**
daß der Speicherkondensator (12) ein Grabenkondensator ist.

13. Logikelement (70) nach Anspruch 12
**dadurch gekennzeichnet,**
daß das Dummy-Element (14) die Struktur des Speicherkondensatorgrabens aufweist.

14. Logikelement (70) nach einem der Ansprüche 11 bis 13
**dadurch gekennzeichnet,**
daß das Dummy-Element (14) die Struktur des Speicherkondensators (12) aufweist.

15. Logikelement (70) nach einem der Ansprüche 11 bis 14
**dadurch gekennzeichnet,**
daß das Schaltelement (51, 52) ein Transistor, insbesondere ein MOS-Transistor ist.

16. Verfahren zum Entwurf eines anwendungsspezifischen integrierten Halbleiterprodukts, das zumindest eine Speichereinheit aufweist, die aus einer Vielzahl von Speicherzellen aufgebaut ist, welche jeweils zumindest einen Speicherkondensator aufweisen, welcher nach einem vorbestimmten Herstellungsprozeß gefertigt wird, mit den Schritten:
a) das Layout des integrierten Halbleiterprodukts wird gemaß der vorgegenen Anwendung entworfen,
b) die zur Durchführung des vorbestimmten Herstellungsproeßes notwendigen Dummy-Elemente werden in das Layout eingefügt.
